# FASCICULE DE BREVET EUROPEEN

(11) **EP 0 641 083 B1**
(45) Date de publication et mention de la délivrance du brevet: **13.01.1999**
(21) Numéro de dépôt: 94410070.0
(22) Date de dépôt: 29.08.1994
(51) Int. Cl.: H03L 7/197, H03L 7/081

(54) **Synthétiseur de fréquence à boucle à vérrouillage de phase numérique comprenant un diviseur de fréquence à rapport fractionnel**
Frequenzsynthetisierer mit digitalem Phasenregelkreis, der einen Frequenzteiler mit rationalem Teilungsverhältnis enthält
Frequency synthetiser comprising a digital PLL with a frequency diviser having a fractional ratio

(30) Priorité: 31.08.1993 FR 9310577
(43) Date de publication de la demande: 01.03.1995
(73) Titulaire: SGS-THOMSON MICROELECTRONICS S.A., 94250 Gentilly (FR)
(72) Inventeur: Meyer, Jacques, F-38700 Corenc (FR)
(74) Mandataire: de Beaumont, Michel

(56) Documents cités:
- WO-A-92/04767
- GB-A- 2 107 142
- GB-A- 2 228 840
- US-A- 3 928 813

## Description

La présente invention concerne un synthétiseur de fréquence servant, dans un PLL numérique, d'oscillateur commandé en tension.

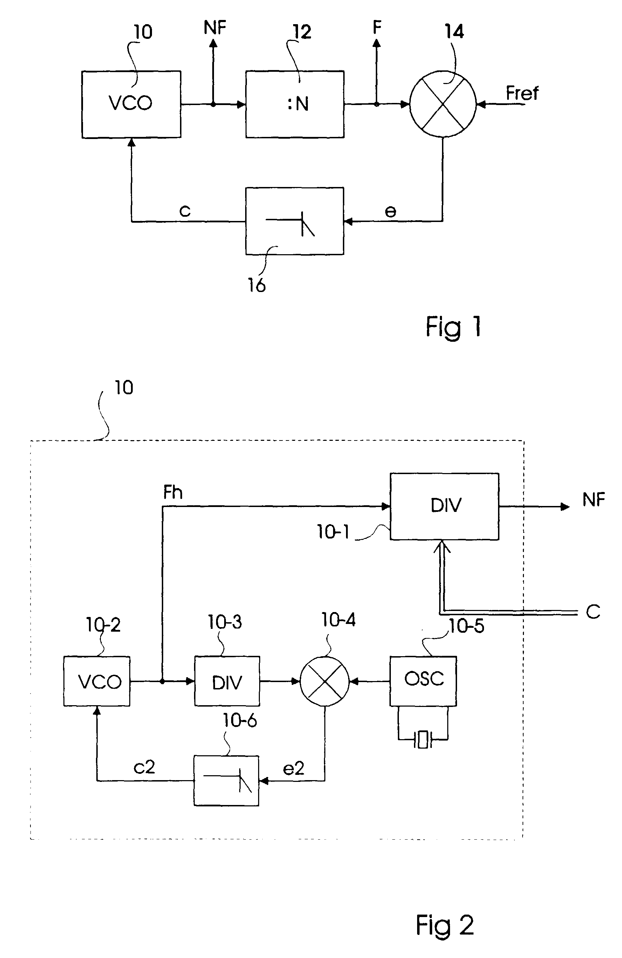

La figure 1 représente schématiquement une architecture classique de PLL. Le PLL comprend un oscillateur commandé en tension (VCO) 10 délivrant une fréquence NF à un diviseur par N 12. Un comparateur de phase 14 reçoit la fréquence de sortie F du diviseur 12 et une fréquence de référence Fref. Le comparateur de phase 14 fournit un signal d'erreur de phase e à un filtre 16 dont la sortie c commande l'oscillateur 10. En régime établi, le signal F est calé en phase et en fréquence sur le signal Fref. Dans une application courante, par exemple dans le balayage horizontal d'un téléviseur, la fréquence de balayage F est de l'ordre de 15 kHz, la fréquence NF de l'ordre de 12 MHz (N = 768), et le filtre 16 est un filtre passe-bas dont la fréquence de coupure est de quelques centaines de hertz.

Actuellement, on tend à réaliser tous les éléments d'un PLL sous forme de circuits numériques. Ceci permet d'éviter l'emploi de capacités de grande valeur difficilement intégrables, de rendre les éléments programmables, et de simplifier les opérations de conception en permettant d'utiliser des blocs standards en technologie MOS ou CMOS.

La figure 2 représente un mode de réalisation d'un oscillateur commandé 10 numérique, dans le cas où le filtre 16 est numérique et fournit un signal de correction numérique C. L'équivalent numérique d'un oscillateur commandé est un synthétiseur de fréquence. Pour générer le signal NF, on divise généralement un signal d'horloge Fh de fréquence plus élevée que celle du signal NF par un diviseur programmable 10-1. Le diviseur 10-1 reçoit en tant qu'information de programmation le signal de correction numérique C. Plus la fréquence Fh est élevée par rapport à la fréquence NF synthétisée, meilleure est la précision ou la résolution de cette fréquence synthétisée.

Dans un système de balayage horizontal de téléviseur, le signal NF est de l'ordre de 12 MHz. La fréquence Fh la plus élevée que l'on puisse obtenir avec les technologies courantes est de l'ordre de 100 à 300 MHz. La fréquence Fh doit être particulièrement stable. Une manière d'obtenir une fréquence stable si élevée est d'utiliser un multiplieur de fréquence qui n'est autre qu'un PLL analogique auxiliaire. Ce PLL analogique comprend un oscillateur commandé 10-2 fournissant la fréquence Fh au diviseur programmable 10-1 et à un diviseur 10-3. Un comparateur de phase 10-4 reçoit la sortie du diviseur 10-3 et la sortie d'un oscillateur à quartz 10-5. La sortie e2 du comparateur 10-4 est fournie à un filtre 10-6 qui fournit à son tour un signal de correction c2 à l'oscillateur commandé 10-2.

Le PLL multiplieur de fréquence qui vient d'être décrit fonctionne à une fréquence particulièrement élevée. De ce fait, les capacités nécessaires à la réalisation du PLL, notamment les capacités du filtre 10-6, sont de taille réduite et intégrables. La fréquence d'horloge Fh est égale à la fréquence de l'oscillateur 10-5 multipliée par le taux de division du diviseur 10-3. L'oscillateur 10-5 n'est pas entièrement intégrable mais il n'est généralement pas nécessaire de le prévoir. En effet, le signal que cet oscillateur est supposé fournir peut être un quelconque signal d'horloge très souvent disponible dans un circuit intégré comprenant le PLL numérique. La fréquence Fh nécessaire est obtenue en choisissant adéquatement le taux de division du diviseur 10-3.

Si l'on veut obtenir une fréquence NF avec une bonne résolution, il faut que le taux de division K du diviseur 10-1 soit grand, ou encore, que la fréquence Fh soit très supérieure à la fréquence NF. Toutefois, la fréquence Fh est en pratique limitée à quelques centaines de MHz. On choisira par exemple environ 220 MHz, ce qui amène à utiliser un taux de division bas compris entre 18 et 19 pour obtenir un signal NF d'environ 12 MHz dans un PLL de balayage horizontal de téléviseur.

La figure 3 représente un synthétiseur de fréquence numérique classique tel que décrit dans le document GB-A-2 107 142 permettant de diviser une fréquence haute Fh par un nombre non entier. La donnée de programmation C est séparée en une partie entière Int(C)=K, correspondant par exemple à quelques bits de poids fort de la donnée C, et en une partie fractionnelle Frac(C) correspondant aux bits restants de poids faible de la donnée C. La partie entière K est fournie à une première entrée d'un additionneur 20. L'additionneur 20 fournit à un diviseur programmable classique 22 la somme de la partie entière K et d'un bit de retenue Cout fourni par un deuxième additionneur 24. Ce bit de retenue est fourni, soit à une deuxième entrée de l'additionneur 20, soit à une entrée de retenue de l'additionneur 20, la deuxième entrée de l'additionneur 20 recevant alors la valeur 0. Le diviseur 22 fournit le signal NF à synthétiser en divisant la fréquence haute Fh par K (ou par un facteur correspondant à K).

La partie fractionnelle Frac(C) de la donnée C est fournie à une première entrée de l'additionneur 24. Un registre 25 reçoit la sortie de l'additionneur 24 et le contenu A de ce registre est fourni à une deuxième entrée de l'additionneur 24. Le registre 25 est validé à la cadence du signal NF. L'ensemble de l'additionneur 24 et du registre 25 constitue ce que l'on appelle un "accumulateur", désigné par la référence 26.

Initialement, l'accumulateur (le contenu A du registre 25) est à 0. Le registre 25 reçoit à la cadence du signal NF la somme de son contenu A et de la partie fractionnelle Frac(C). L'accumulateur est prévu pour déborder lorsque la somme des parties fractionnelles successives atteint une valeur correspondant à une unité du taux de division K. Au moment du débordement, la valeur K fournie au diviseur programmable est incrémentée de 1 seulement pendant un cycle du signal NF.

Avec cette configuration, la fréquence haute Fh est tantôt divisée par K, tantôt par K+1, le rapport entre le nombre de fois où l'on divise par K+1 et le nombre de fois où l'on divise par K étant égal à la partie fractionnelle de la donnée C. Ainsi, la fréquence moyenne du signal synthétisé NF est égale à la fréquence Fh divisée par le nombre non entier souhaité.

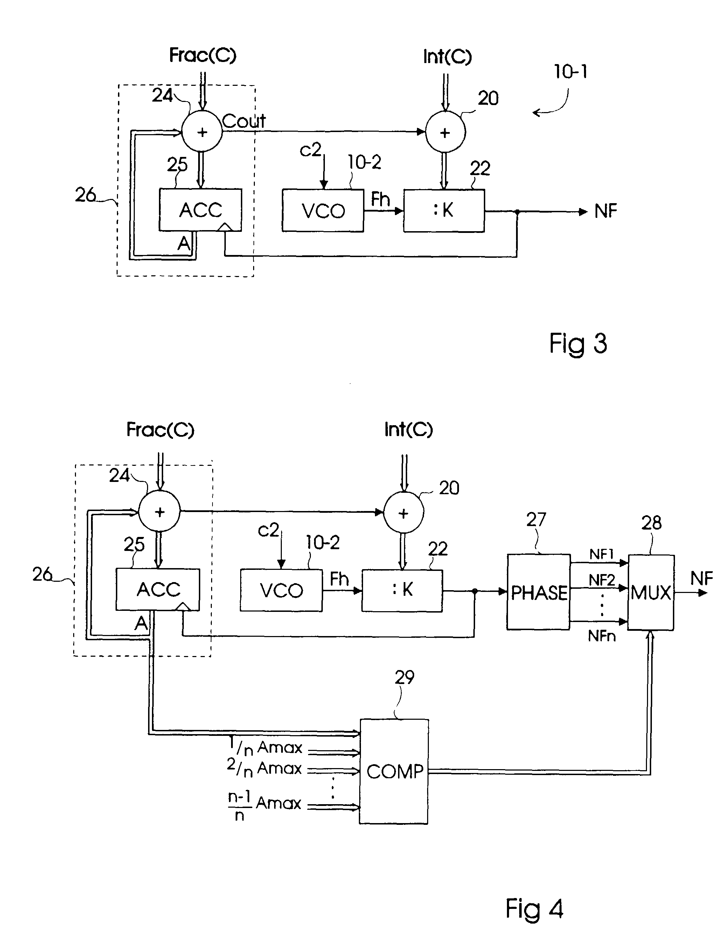

En utilisant le synthétiseur de la figure 3 dans un PLL numérique, on obtient une bonne précision en fréquence du signal F généré par le PLL, puisque, pour l'obtenir, le signal NF et son erreur de fréquence sont divisés par un nombre élevé (de l'ordre de 768 dans l'exemple du balayage horizontal d'un téléviseur) par le diviseur 12.

Toutefois, la fréquence F générée par le PLL présente une fluctuation de période aléatoire (jitter) égale à la période de la fréquence haute Fh. Dans certaines applications, comme par exemple dans le balayage horizontal d'un téléviseur, cette fluctuation de période est imperceptible à l'écran avec une fréquence Fh maximale de 220 MHz. Par contre, si le PLL est utilisé dans des moniteurs à haute fréquence de balayage, la fluctuation de période devient visible.

Dans le document GB-A-2 107 142, le problème de la fluctuation de période est résolu en introduisant dans la boucle à verrouillage de phase une correction de phase en sortie du diviseur de fréquence.

Un objet de la présente invention est de prévoir un synthétiseur de fréquence à utiliser dans un PLL numérique, qui permette d'obtenir une fluctuation de période particulièrement faible du signal généré par le PLL.

Pour atteindre cet objet, il est prévu, selon l'invention, d'utiliser un synthétiseur à accumulation du type de celui de la figure 3. A partir de la fréquence d'horloge Fh, on génère n signaux à la fréquence du signal NF à synthétiser, appelés phases du signal NF. Une phase est en retard par rapport à la précédente du n-ième, approximativement, de la période du signal d'horloge Fh. Un comparateur à n fenêtres reçoit le contenu A de l'accumulateur et sélectionne en tant que signal de sortie NF la phase dont le rang correspond à celui de la fenêtre dans laquelle se trouve le contenu de l'accumulateur.

La présente invention prévoit plus particulièrement un synthétiseur de fréquence fournissant un signal synthétisé, comprenant un oscillateur fournissant un signal d'horloge rapide à un diviseur programmable par une donnée numérique, les bits de poids fort de la donnée numérique étant fournis au diviseur programmable et les bits de poids faible à un accumulateur coopérant avec le diviseur programmable pour incrémenter d'une unité son rang de division lorsque l'accumulateur déborde. Le synthétiseur comprend un générateur de n phases de retards croissants du signal synthétisé ; des moyens de comparaison du contenu de l'accumulateur à n plages de valeurs possibles croissantes ; et des moyens de sélection, en tant que signal synthétisé, de la phase dont le rang correspond à celui de la plage dans laquelle est compris le contenu de l'accumulateur.

Selon un mode de réalisation de la présente invention, le synthétiseur comprend un oscillateur délivrant un nombre impair n de phases d'horloge de même fréquence et en retard l'une par rapport à la précédente d'un n-ième de période d'horloge, les phases du signal synthétisé étant obtenues à partir de phases d'horloge respectives.

Selon un mode de réalisation de la présente invention, l'une des phases d'horloge est fournie au diviseur programmable de manière que ce dernier fournisse une phase initiale du signal synthétisé, les autres phases du signal synthétisé étant obtenues en synchronisant la phase initiale du signal synthétisé sur les phases d'horloge restantes respectivement, une phase du signal synthétisé étant sélectionnée en tant que signal synthétisé par un multiplexeur commandé par lesdits moyens de comparaison.

Selon un mode de réalisation de la présente invention, les phases du signal synthétisé sont obtenues par des bascules connectées en série après le diviseur programmable et validées de manière entrelacée par les phases d'horloge.

Selon un mode de réalisation de la présente invention, les bascules sont connectées de manière qu'une bascule de rang i est validée par la phase d'horloge de rang n+2-i (modulo n), et fournit la phase de rang n-i (modulo n) du signal synthétisé par l'intermédiaire d'un circuit de retard de n-i-1 cycles d'horloge.

Ces objets, caractéristiques et avantages ainsi que d'autres de la présente invention seront exposés en détail dans la description suivante de modes de réalisation particuliers faite à titre non limitatif en relation avec les figures jointes parmi lesquelles :
la figure 1, précédemment décrite, représente schématiquement une boucle à verrouillage de phase (PLL) classique ;
la figure 2 représente un mode de réalisation de synthétiseur de fréquence permettant d'obtenir sous forme numérique l'oscillateur commandé du PLL de la figure 1 ;
la figure 3 représente un mode de réalisation de synthétiseur de fréquence permettant d'effectuer une division par un nombre non entier ;
la figure 4 représente un mode de réalisation généralisé d'un synthétiseur de fréquence selon l'invention ;
la figure 5 représente un mode de réalisation particulier d'un synthétiseur de fréquence selon l'invention ;
la figure 6 représente les allures de divers signaux utilisés dans le synthétiseur de la figure 4 ;
la figure 7 représente des variations d'erreur de phase obtenues en utilisant un synthétiseur selon l'invention dans un PLL ; et
la figure 8 illustre une configuration entrelacée de bascules pour obtenir n signaux destinés à former le signal de sortie du synthétiseur.

Dans la figure 4, un synthétiseur de fréquence selon l'invention est construit autour d'un synthétiseur à accumulation du type de la figure 3. La fréquence d'horloge Fh à fournir au synthétiseur est générée par un PLL auxiliaire du type de la figure 2. Dans les figures, des mêmes références désignent des mêmes éléments.

Selon l'invention, un générateur de phases 27 reçoit la sortie du diviseur 22. Ce générateur 27 fournit n signaux NF1, NF2... NFn à un multiplexeur 28. Les signaux NF1 à NFn sont à la fréquence du signal NF à synthétiser mais en retard l'un par rapport au précédent du n-ième de la période du signal d'horloge Fh. On dira que le générateur 27 fournit n phases du signal NF. L'homme du métier peut obtenir ces phases de nombreuses manières, par exemple en retardant une phase par rapport à la précédente à l'aide de circuits de retard. Un exemple détaillé sera exposé ultérieurement.

Le contenu A de l'accumulateur 26, qui indique en fait l'erreur de phase du signal NF synthétisé par rapport au signal NF souhaité, est exploité par un comparateur à n fenêtres 29 pour sélectionner parmi les phases, celle dont le front actif (par exemple montant) est le plus proche du front montant souhaité du signal NF. Le comparateur 29 reçoit le contenu A de l'accumulateur 26 et les valeurs Amax/n, 2Amax/n... (n-1)Amax/n définissant les bornes intermédiaires des n fenêtres (Amax désigne le contenu maximal de l'accumulateur). Lorsque la valeur A se trouve dans une fenêtre de rang i (délimitée par les valeurs (i-1)Amax/n et iAmax/n), le multiplexeur 28 est commandé pour sélectionner la phase NFi.

Avec cette configuration, la fluctuation de période du signal F généré par un PLL incorporant le synthétiseur, est divisée par n.

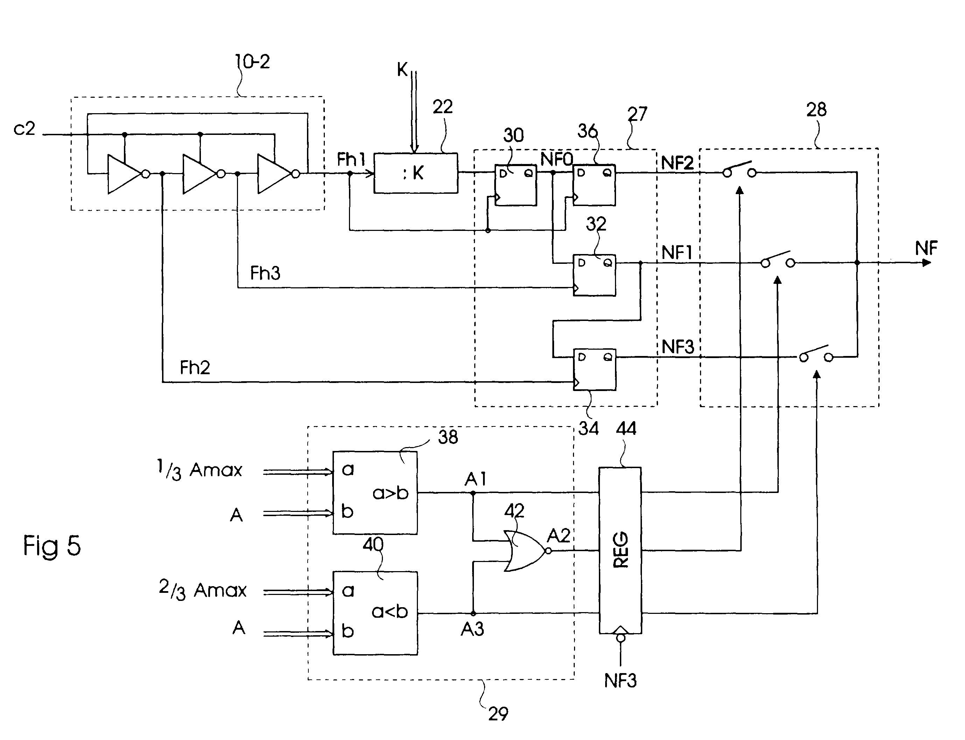

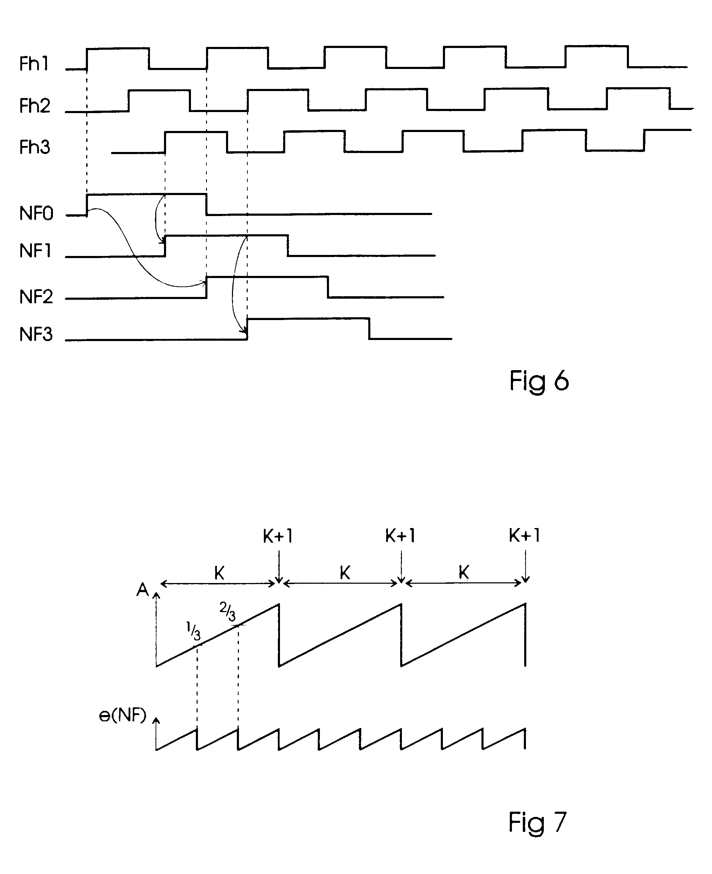

La figure 5 représente un mode de réalisation particulier de synthétiseur de fréquence selon l'invention. La description de la figure 5 sera mieux comprise si l'on se réfère également à la figure 6 qui représente les allures de diverses phases de signaux utilisés selon l'invention.

A la figure 5, on utilise un oscillateur commandé 10-2 fournissant n=3 signaux d'horloge (Fh1, Fh2, Fh3) à la fréquence d'horloge Fh. Un signal d'horloge, appelé phase d'horloge, est en retard par rapport au précédent du tiers de la période d'horloge. L'oscillateur commandé 10-2 est, par exemple, un oscillateur en anneau à trois inverseurs dont le courant d'alimentation est réglé par le signal de commande c2 susmentionné. Aux sorties de ces inverseurs, on prélève les phases d'horloge respectives Fhl, Fh2 et Fh3. La phase Fh1 est fournie au diviseur 22 du synthétiseur de la figure 3. On cherche à obtenir des phases NF1, NF2 et NF3 du signal NF à synthétiser, les phases NF2 et NF3 étant en retard par rapport à la phase NF1 de respectivement un tiers et deux tiers de période du signal d'horloge Fh.

Dans le mode de réalisation particulier représenté, la sortie du diviseur 22 est synchronisée sur la phase Fh1 par une bascule 30 pour obtenir une phase intermédiaire NF0 du signal NF. Cette phase NF0 est synchronisée sur la phase Fh3 par une bascule 32 pour obtenir la phase NF1. La phase NF1 est synchronisée sur la phase Fh2 par une bascule 34 pour obtenir la phase NF3. La phase NF2 est obtenue en retardant la phase NFO d'une période de la phase Fh1 par une bascule 36.

Un multiplexeur 28 formé d'interrupteurs S1 à S3 permet de fournir, en tant que signal synthétisé NF, une phase adéquate parmi les phases NF1 à NF3. Ces interrupteurs sont commandés par un comparateur à fenêtre 29 décrit ci-dessous.

Un premier comparateur simple 38 reçoit sur une entrée a un tiers de la valeur maximale Amax que peut contenir l'accumulateur 26. Une entrée b reçoit le contenu A de l'accumulateur. L'interrupteur S1 est commandé par la sortie A1 du comparateur 38, qui est active lorsque le contenu A de l'accumulateur 26 est inférieur au tiers de la valeur maximale.

Un deuxième comparateur simple 40 reçoit sur une entrée a deux tiers de la valeur maximale Amax et sur une entrée b le contenu A de l'accumulateur 26. L'interrupteur S3 est commandé par la sortie A3 du comparateur 40, qui est active lorsque le contenu A de l'accumulateur est supérieur à deux tiers de la valeur maximale. L'interrupteur S2 est commandé par la sortie A2 d'une porte NON OU 42 recevant les signaux A1 et A3 ; le signal A2 est actif lorsque les signaux A1 et A3 sont tous deux inactifs, ce qui est le cas lorsque le contenu A de l'accumulateur 26 est compris entre un tiers et deux tiers de la valeur maximale Amax. Les éléments 38 à 42 constituent un comparateur à trois fenêtres de même largeur.

Un registre 44, validé par l'inverse de la dernière phase (NF3) du signal NF, permet de transmettre les états A1 à A3 aux interrupteurs S1 à S3 après le front descendant de la phase NF3, quand les phases NF1 à NF3 sont toutes à 0. Ceci évite tout problème lié à la rapidité de commutation ; la commutation peut s'effectuer à tout instant dans un grand intervalle de temps compris entre le front descendant de la phase NF3 et le prochain front montant de la phase NF1. Si l'on permettait aux interrupteurs S1 à S3 de commuter avant le front descendant de la phase NF3, le signal NF risquerait de présenter un passage intempestif à 0 entre l'instant de commutation et la survenue du front montant de la phase NF2 ou NF3 nouvellement sélectionnée. Si la commutation doit se produire avec un retard d'un certain nombre de cycles du signal synthétisé NF, les signaux A1 à A3 seront retardés corrélativement par des bascules validées par le signal NF.

La figure 7 représente la variation du contenu A de l'accumulateur 26, et la variation correspondante, obtenue grâce au synthétiseur de la figure 4, de l'erreur de phase e(NF) du signal synthétisé NF. En régime établi, initialement, le registre 25 est à 0 et le rang de division du diviseur 22 est K. La phase choisie pour le signal NF est alors NF1. A chaque cycle du signal NF, le contenu A du registre 25 est augmenté, ce qui correspond au fait que l'erreur de phase e(NF) (avance de phase) entre le signal NF synthétisé et le signal NF souhaité augmente. En effet, le taux de division souhaité est compris entre K et K+1 alors que le taux de division utilisé ici est K.

Lorsque le contenu A du registre 25 atteint un tiers de sa valeur maximale, la phase suivante NF2 est sélectionnée en tant que signal NF. Au moment précis de cette commutation, l'erreur de phase e(NF) est rattrapée, mais elle augmente de nouveau.

Lorsque le contenu A du registre 25 atteint deux tiers de sa valeur maximale, la phase NF3 est sélectionnée en tant que signal NF. Au moment précis de la commutation, l'erreur de phase e(NF) est de nouveau rattrapée mais recommence à augmenter. L'erreur de phase e(NF) augmente jusqu'au moment où le registre 25 déborde et que le taux de division du diviseur 22 devient K+1 pendant un cycle du signal NF. Alors, la phase NF1 est de nouveau sélectionnée et le cycle recommence lorsque le taux de division du diviseur 22 redevient K.

Ainsi, le synthétiseur de la figure 5 permet d'ajuster la phase du signal synthétisé NF à la phase souhaitée par autant de paliers successifs que l'oscillateur 10-2 fournit de phases d'horloge, ce qui permet de diviser l'erreur de phase par le nombre de phases d'horloge 10-2. En conséquence, la fluctuation de période (jitter) du signal F généré par un PLL incorporant un synthétiseur selon l'invention, est divisée par le nombre de phases d'horloge.

Dans la figure 5, les bascules 30 à 34 sont connectées en série mais validées de manière "entrelacée", c'est-à-dire, par exemple, que la bascule validée par la phase d'horloge Fh3 reçoit la sortie de la bascule validée par la phase Fh1 (au lieu de Fh2). Elles sont ainsi connectées pour que la validation d'une bascule survienne deux tiers de période d'horloge Fh après la validation de la bascule précédente. Si les bascules étaient connectées de manière non entrelacée, une bascule courante serait validée seulement un tiers de période après la bascule précédente et il est fort possible, à la fréquence élevée de fonctionnement, qu'au moment de la validation de la bascule courante, la sortie de la bascule précédente n'ait pas encore eu le temps d'atteindre sa valeur finale. Bien entendu, les bascules sont connectées de manière non entrelacée si la fréquence de fonctionnement est suffisamment basse pour le permettre.

Les bascules 30 à 36 peuvent être supprimées si l'on utilise un diviseur programmable 22 pour chacune des phases Fh1 à Fh3. Cette solution serait toutefois consommatrice de surface de silicium.

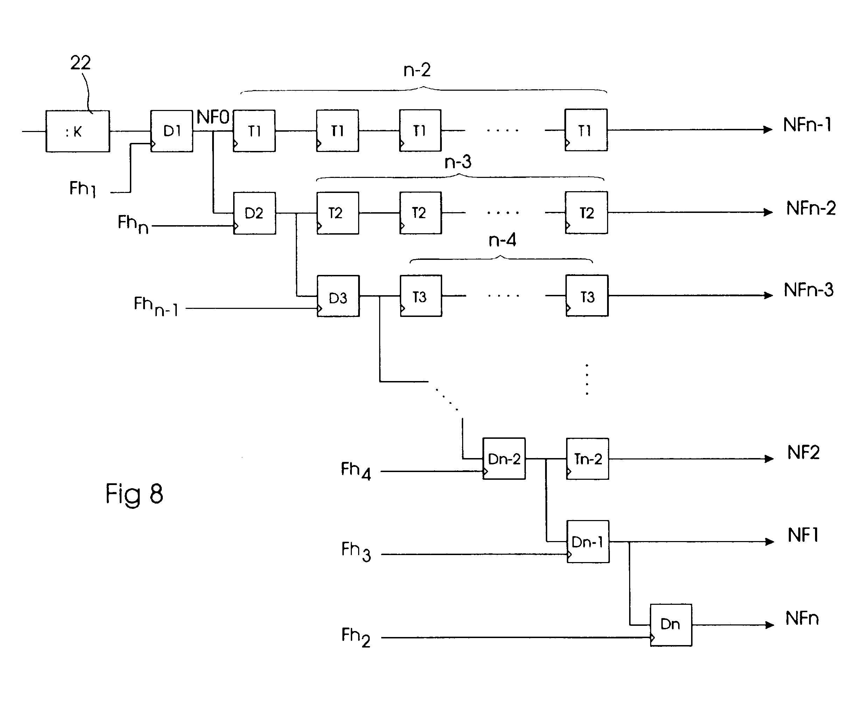

La figure 8 illustre une configuration entrelacée de bascules pour obtenir n phases NF1 à NFn du signal synthétisé à partir de n phases d'horloge Fh1 à Fhn de déphasages croissants. A la sortie du diviseur 22, n bascules D1 à Dn sont disposées en série.

La bascule D1 reçoit la sortie du diviseur 22 et fournit la phase NFn-1 du signal synthétisé après un retard de n-2 cycles d'horloge par n-2 bascules T1. Les bascules D1 et T1 sont validées par la phase d'horloge Fh1.

Une bascule Di reçoit la sortie de la bascule Di-1 et est validée par la phase d'horloge Fhₙ₊₂₋ᵢ. La sortie de la bascule Di est retardée de n-i-1 cycles d'horloge par n-i-1 bascules Ti avant de fournir la phase NFn-i du signal synthétisé. Les bascules Ti sont validées par la phase d'horloge Fhₙ₊₂₋ᵢ. Aucun retard n'est prévu pour les bascules Dn-1 et Dn (n-i-1≤0). Les valeurs n+2-i et n-i sont comprises entre 1 et n (elles sont définies modulo n).

Avec cette configuration, une bascule est validée 1-1/n période d'horloge après la précédente, ce qui laisse aux bascules une importante marge pour commuter, même si le nombre n est grand.

Bien entendu, l'homme du métier peut trouver d'autres connexions entrelacées, qui seront toutefois moins avantageuses.

## Revendications

1. Synthétiseur de fréquence fournissant un signal synthétisé (NF), comprenant un oscillateur (10-2) fournissant un signal d'horloge rapide (Fh) à un diviseur programmable (22) par une donnée numérique (C), les bits de poids fort (K) de la donnée numérique étant fournis au diviseur programmable et les bits de poids faible à un accumulateur (26) coopérant avec le diviseur programmable pour incrémenter d'une unité son rang de division lorsque l'accumulateur déborde, caractérisé en ce qu'il comprend :
- un générateur (27) de n phases (NF1 à NFn) de retards croissants du signal synthétisé (NF) ;
- des moyens de comparaison (29) du contenu (A) de l'accumulateur à n plages de valeurs possibles croissantes ; et
- des moyens de sélection (28), en tant que signal synthétisé, de la phase dont le rang correspond à celui de la plage dans laquelle est compris le contenu de l'accumulateur.

2. Synthétiseur selon la revendication 1, caractérisé en ce qu'il comprend un oscillateur (10-2) délivrant un nombre impair n de phases d'horloge de même fréquence et en retard l'une par rapport à la précédente d'un n-ième de période d'horloge, les phases du signal synthétisé étant obtenues à partir de phases d'horloge respectives.

3. Synthétiseur selon la revendication 2, caractérisé en ce que l'une des phases d'horloge (Fh1) est fournie au diviseur programmable de manière que ce dernier fournisse une phase initiale (NF0) du signal synthétisé, les autres phases du signal synthétisé étant obtenues en synchronisant la phase initiale du signal synthétisé sur les phases d'horloge restantes respectivement, une phase du signal synthétisé étant sélectionnée en tant que signal synthétisé par un multiplexeur (28) commandé par lesdits moyens de comparaison (29).

4. Synthétiseur selon la revendication 3, caractérisé en ce que les phases (NF1, NF2, NF3) du signal synthétisé sont obtenues par des bascules (30, 32, 34) connectées en série après le diviseur programmable (22) et validées de manière entrelacée par les phases d'horloge (Fh1, Fh2, Fh3).

5. Synthétiseur selon la revendication 4, caractérisé en ce que lesdites bascules sont connectées de manière qu'une bascule de rang i (Di) est validée par la phase d'horloge de rang n+2-i (modulo n), et fournit la phase (NFn-i) de rang n-i (modulo n) du signal synthétisé par l'intermédiaire d'un circuit de retard (Ti) de n-i-1 cycles d'horloge.

## Patentansprüche

1. Frequenz-Synthetisator zur Erzeugung eines synthetisierten Signals (NF), mit einem Oszillator (10-2), der einem durch ein digitales Datum (eine digitale Datengröße) (C) programmierbaren Teiler (22) ein schnelles (hochfrequentes) Taktsignal (Fh) zuführt, wobei die Bits (K) hoher Signifikanz des digitalen Datums dem programmierbaren Teiler und die Bits geringer Signifikanz einem Akkumulator (26) zugeführt werden, der mit dem programmierbaren Teiler zusammenwirkt, um dessen Teilungsrang um eine Einheit zu erhöhen, wenn der Akkumulator überläuft,
**dadurch gekennzeichnet,** daß
er umfaßt:
- einen Generator (27) zur Erzeugung von n ansteigend verzögerten Phasen (NF1 bis NFn) des synthetisierten Signals (NF);
- Vergleichsmittel (29) zum Vergleichen des Inhalts (A) des Akkumulators mit n Bereichen möglicher ansteigender Werte;
- Selektionsmittel (28) zur Auswahl derjenigen Phase, deren Rang dem des Bereichs entspricht, in welchem der Inhalt des Akkumulators liegt, als synthetisiertes Signal.

2. Synthetisator nach Anspruch 1, dadurch gekennzeichnet, daß er einen Oszillator (10-2) aufweist, der eine ungerade Anzahl n von Taktphasen derselben Frequenz liefert, deren jede gegenüber der vorhergehenden jeweils um ein n-tel der Taktperiode verzögert ist, wobei die Phasen des synthetisierten Signals aus entsprechenden Taktphasen abgeleitet werden.

3. Synthetisator nach Anspruch 1, dadurch gekennzeichnet, daß eine der Taktphasen (Fh1) dem programmierbaren Teiler so zugeführt wird, daß dieser eine anfängliche Phase (NF0) des synthetisierten Signals erzeugt, während die anderen Phasen des synthetisierten Signals durch Synchronisation der Anfangsphase des synthetisierten Signals mit den entsprechenden übrigen Taktphasen erhalten werden, und daß eine Phase des synthetisierten Signals von einem durch die genannten Vergleichsmittel (29) gesteuerten Multiplexer (28) als synthetisiertes Signal ausgewählt wird.

4. Synthetisator nach Anspruch 3, dadurch gekennzeichnet, daß die Phasen (NF1, NF2, NF3) des synthetisierten Signals mit Kippschaltungen (30, 32, 34) erhalten werden, die in Reihe hinter dem programmierbaren Teiler (22) geschaltet sind und durch die Taktphasen (Fh1, Fh2, Fh3) aktiviert werden.

5. Synthetisator nach Anspruch 4, dadurch gekennzeichnet, daß die Kippstufen so angeschlossen sind, daß eine Kippstufe des Rangs i (Di) durch die Taktphase vom Rang n+2-i (modulo n) aktiviert wird und mittels einer Verzögerungsschaltung (Ti) mit Verzögerung um n-i-1 Taktzyklen die Phase (NFn-i) vom Rang n-i (modulo n) des synthetisierten Signals liefert.

## Claims

1. A frequency synthesizer providing a synthesized signal (NF), including an oscillator (10-2) that supplies a fast clock signal (Fh) to a divider (22) programmable by a digital data (C), the most significant bits (K) of the digital data being provided to the programmable divider, and the least significant bits being provided to an accumulator (26) that cooperates with the programmable divider to increment by one unit its division rank when the accumulator overflows, characterized in that it includes:
- a generator (27) for generating n phases (NF1-NFn) of the synthesized signal (NF) having increasing delays;
- means (29) for comparing the content (A) of the accumulator with n ranges of possible increasing values; and
- means (28) for selecting, as the synthesized signal, the phase whose rank corresponds to the rank of the range within which the content of the accumulator is comprised.

2. The synthesizer of claim 1, characterized in that it includes an oscillator (10-2) providing an odd number n of clock phases having the same frequency and delayed one with respect to the preceding by one n-th of the clock period, the phases of the synthesized signal being obtained from respective clock phases.

3. The synthesizer of claim 2, characterized in that one the clock phases (Fh1) is provided to the programmable divider so that the programmable divider provides an initial phase (NF0) of the synthesized signal, the other phases of the synthesized signal being obtained by synchronizing the initial phase of the synthesized signal with the remaining clock phases, respectively, one phase of the synthesized signal being selected as the synthesized signal through a multiplexer (28) controlled by said comparison means (29).

4. The synthesizer of claim 3, characterized in that the phases (NF1, NF2, NF3) of the synthesized signal are obtained through flip-flops (30, 32, 34) connected in series after the programmable divider (22) and enabled in interleaved mode by the clock phases (Fh1, Fh2, Fh3).

5. The synthesizer of claim 4, characterized in that said flip-flops are connected so that a flip-flop of rank i (Di) is enabled by the clock phase of rank n+2-i (modulo n), and provides the phase (NFn-i) of rank n-i (modulo n) of the synthesized signal through a delay circuit (Ti) of n-i-1 clock cycles.
